Europäisches Patentamt

(19) European Patent Office

Office européen des brevets

(11) Publication number: **0 033 345**
**B1**

(12) **EUROPEAN PATENT SPECIFICATION**

(45) Date of publication of patent specification: **27.12.84**

(21) Application number: **80901736.1**

(22) Date of filing: **25.07.80**

(86) International application number:
**PCT/US80/00927**

(87) International publication number:
**WO 81/00420 19.02.81 Gazette 81/05**

(51) Int. Cl.³: **C 23 C 15/00**

(54) **HIGH CAPACITY ETCHING APPARATUS.**

(30) Priority: **09.08.79 US 65185**
**20.12.79 US 105620**

(43) Date of publication of application:
**12.08.81 Bulletin 81/32**

(45) Publication of the grant of the patent:
**27.12.84 Bulletin 84/52**

(84) Designated Contracting States:
**DE FR GB NL**

(56) References cited:
**FR-A-2 308 200**
**US-A-3 844 924**
**US-A-3 855 110**
**US-A-3 879 597**
**US-A-3 897 325**
**US-A-3 998 718**
**US-A-4 126 530**
**US-A-4 222 839**

(73) Proprietor: **Western Electric Company,**
**Incorporated**
**222 Broadway**
**New York, NY 10038 (US)**

(72) Inventor: **LEPSELTER, Martin Paul**
**25 Sweetbriar Road**
**Summit, NJ 07901 (US)**
Inventor: **MAYDAN, Dan**
**14 Vincent Lane**
**Short Hills, NJ 07078 (US)**

(74) Representative: **Lawrence, Brian Richard et al**
**Western Electric Company Limited 5,**
**Mornington Road**
**Woodford Green Essex IG8 OTU (GB)**

EP 0 033 345 B1

Courier Press, Leamington Spa, England.

## Description

This invention relates to dry etching apparatus of the type that does not include a magnetic field, comprising first and second electrode elements, one of the electrode elements being capacitively coupled to and driven by a source of a-c power, and means including the a-c power source for establishing a gas discharge between the first and second electrodes and for eroding material from a workpiece located in contact with one of the electrodes.

Considerable interest exists in employing dry processing techniques for patterning workpieces such as semiconductor wafers. The interest in dry processing techniques stems from their generally better resolution and improved dimensional and shape control capabilities relative to standard wet etching (i.e. techniques using a liquid etchant). Thus, dry etching is being utilized increasingly for, for example, pattern delineation in the processing of semiconductor wafers to form large-scale-integrated (LSI) devices.

Various dry etching processes that involve radio-frequency-generated plasmas are known. These processes include sputter etching which is described, for example, in J. Vac. Sci. Technol., Vol. 13, No. 5, pp. 1008—1022, Sept/Oct. 1976, and reactive sputter etching which is described, for example, in *Proc. 6th Int'l. Vacuum Congr. 1974, Japan, J. Appl. Phys.*, suppl. 2, pt 1, pp. 435—438, 1974.

Heretofore, so-called parallel-plate reactors have been utilized for sputter etching or reactive sputter etching of workpieces such as semiconductor wafers. In many cases of practical importance, however, it has been recognised that the throughput characteristics (or speed of processing) of available reactors have not been adequate for large-scale production of LSI devices. Accordingly, efforts have been directed at trying to devise high-throughput etching equipment that would be capable of simultaneously processing a relatively large number of workpieces. It was recognised that such equipment, if available, could substantially decrease the cost of devices processed therein.

Hence, an object of the present invention is to provide improved dry etching apparatus. More specifically, an object of this invention is to provide dry etching apparatus capable of simultaneously etching a number of workpieces at a relatively fast rate.

These objects are attained in dry etching apparatus as foresaid by arranging that the first electrode has a first surface facing the second electrode, the second electrode has second surface which surrounds the first surface, the area of one of said surfaces is smaller than the area of the other surface, a plurality of workpieces are located closely adjacent to or on the smaller area surface, and the electrode having the smaller area surface is capacitively coupled to and driven by the source of a-c power for the purpose of causing a dark space to be formed in the immediate vicinity of said workpieces and a plasma to be formed throughout the space between said dark space and said other surface.

In one embodiment, the central electrode has the smaller surface area and constitutes the cathode. In another embodiment, the central electrode comprises a large number of vanes so that the surrounding annular electrode has the smaller surface area and constitutes the cathode. In either case the ratio of anode surface area to cathode surface area should be in the ranges of 1.5 to 10. Other embodiments and modifications are also described.

Brief Description of the Drawing
In the drawing:
FIG. 1 is a partially broken away depiction of a specific illustrative etching apparatus in accordance with one embodiment of the present invention;
FIG. 2 is a top view of the center member of FIG. 1;
FIG. 3 is a schematic top view of a portion of another specific illustrative etching apparatus in accordance with the principles of the present invention;
FIG. 4 is a depiction similar to FIG. 1 but showing, additionally, a grid element included in a reactive sputter etching apparatus in accordance with the present invention;
FIG. 5 is a schematic top view of the apparatus of FIG. 4;
FIG. 6 is an illustrative etching apparatus in accordance with another embodiment of the present invention;
FIG. 7 is a schematic view of a cross-section of the apparatus of FIG. 6; and
FIGS. 8 and 9 illustrate the manner in which workpieces are secured in the apparatus of FIG. 6.

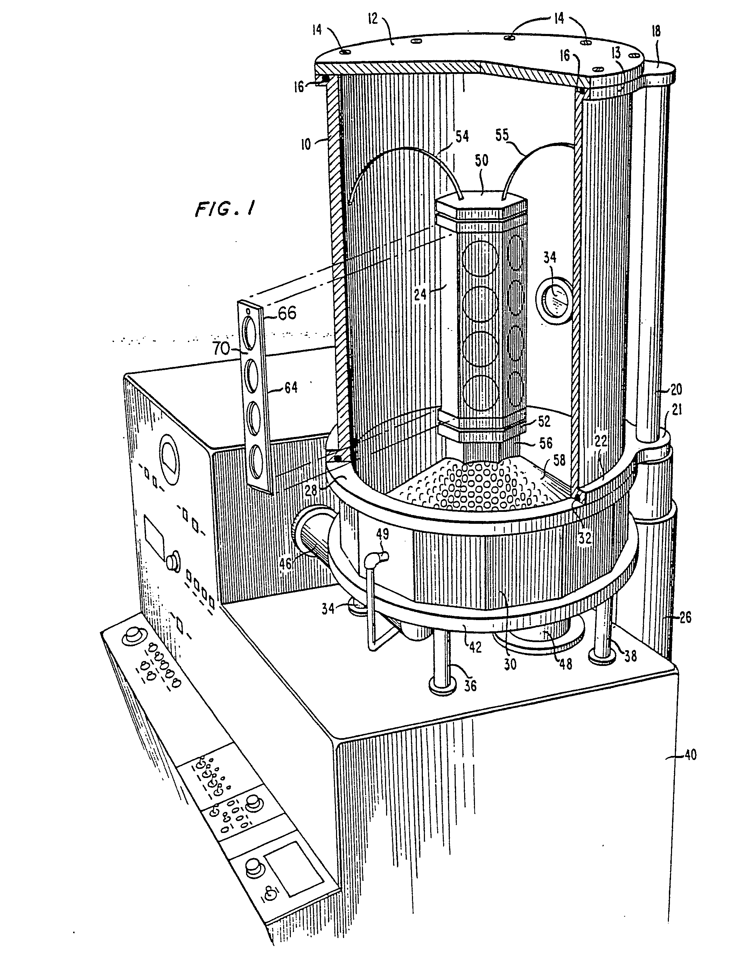

Detailed Description
The specific illustrative system depicted in FIG. 1 comprises a main cylindrical etching chamber 10 made of an electrically conductive material such as, for example, aluminum or stainless steel. By any standard affixing means such as screws 14, a member 12 is secured to an upper flange portion 13 of the cylindrical chamber 10. In addition, the member 12 is sealed to the top of the chamber 10 by a conventional O-ring 16.

Illustratively, the flange portion 13 of the chamber 10 of FIG. 1 includes an extension 18 that is mechanically attached to a supporting arm 20. In turn, the bottom end of the arm 20 is attached to an extension 21 of a lower flange portion 22 of the chamber 10. By means of the arm 20, the chamber 10 can be raised upwards to provide access by an operator to a workpiece holder 24 that is centrally mounted within the depicted apparatus. In one particular illustrative example, the arm 20 is a component part of a standard hydraulic lifting mechanism 26.

When the chamber 10 of FIG. 1 is raised fully upward by means of the arm 20, the holder 24 is rendered accessible for mounting workpieces thereon. The particular illustrative holder 24 shown in FIG. 1 includes six flat surfaces or facets. By way of a specific example, each such surface indicated in FIG. 1 is designed to have four silicon wafers mounted thereon. One illustrative way in which the wafers are so mounted on the holder 24 will be specified in detail later below.

When the chamber 10 is lowered into the position shown in FIG. 1, the lower flange portion 22 rests on the upper rim 28 of a metallic base member 30. A seal is achieved between the chamber 10 and the base member 30 by interposing a conventional O-ring 32 therebetween. With the apparatus of FIG. 1 in its depicted position, observation of the sealed interior of the chamber 10 can be made via a viewing port 34.

A Bottom plate 42 of the base member 30 of FIG. 1 is mechanically supported by columns 34, 36, 38... on one of the top surfaces of auxiliary equipment 40. Two conduits 46 and 48 extend from the equipment 40 through respective openings in the bottom plate 42. The conduit 46 contains therein two fluid-carrying pipes and a conductive bus which are not shown. The fluid carried in the pipes is utilized to cool the workpiece holder 24, and the bus is for the purpose of capacitively coupling a high-frequency voltage source to the holder 24. The conduit 48, which is connected to a standard vacuum pump in the equipment 40, serves to establish a prescribed low-pressure condition in the sealed chamber 10. In addition, an inlet pipe 49 is utilized to introduce a specified gas or mixture of gases into the depicted chamber from the equipment 40.

The schematically depicted equipment 40 represented in FIG. 1 is conventional in nature. It includes, for example, a vacuum system, gas sources, a variable high-frequency alternating-current (a-c) power supply adjustable to operate in, for example, the range 8 kilohertz to 50 megahertz, a pumped source of cooling fluid, and associated standard controls and gauges by means of which specified operating conditions of the type set forth later below are established in the chamber 10. (Herein, for purposes of a specific illustrative example, r-f excitation of the etching apparatus at a frequency of 13.5 megahertz will be assumed.)

In accordance with the principles of the present invention, the a-c or r-f voltage source is connected to the workpiece holder 24 and the chamber 10 is connected to a fixed point of reference potential such as electrical ground. Moreover, the a-c driven holder 24 is electrically insulated from both a top conductive element 50 and a bottom conductive element 52. In turn, the top element 50 is electrically connected to the inner surface of the chamber 10 via conductive strips 54, 55. The bottom element 52 contacts a conductive collar 56 and an apertured conductive member 58. In turn, the bottom edge of the member 58 electrically contacts the base member 30. Thus, the elements 50 and 52, the collar 56 and the member 58 are in effect all electrically connected to the same point of reference potential as is the chamber 10.

The workpiece 24 constitutes the cathode and the chamber 10 constitutes the anode of the depicted apparatus. In accordance with the invention, the anode-to-cathode area ratio $(A_a:A_k)$ is designed to exceed unity. Illustratively, this ratio is selected to be in the range 1.5 to 10. In one specific advantageous system of the type represented in FIG. 1, this ratio was designed to be approximately 2.6. In this embodiment, $A_a:A_k = D_a:D_k$, where $D_a$ is the diameter of the chamber 10 and $D_k$ is the diameter of the holder 24.

The area of the cathode of the apparatus depicted in FIG. 1 is approximately the sum of the surface areas of the six facets of the workpiece holder 24. The area of the anode thereof is approximately the area of the cylindrical band of the inner surface of the chamber 10 that is directly opposite and equal in height to the facets of the holder 24.

Cooling of the holder 24 of the FIG. 1 apparatus is advantageous. Otherwise, heat generated during the etching process may cause material included on the workpiece to flow and thereby deleteriously alter the geometry of the device being fabricated. Moreover, by controlling the temperature of the holder 24 to maintain a specified optimal temperature on the surface thereof, a relatively uniform and efficient etching action is achieved for materials whose etch rates are temperature dependent.

In apparatus made in accordance with the principles of the present invention, a plasma of the type typically utilized in conventional sputter etching or reactive sputter etching is established in the sealed chamber 10. In particular, a symmetrical dark space is formed in the immediate vicinity of the workpiece holder 24 and a plasma is formed between the dark space and the inner wall of the chamber 10.

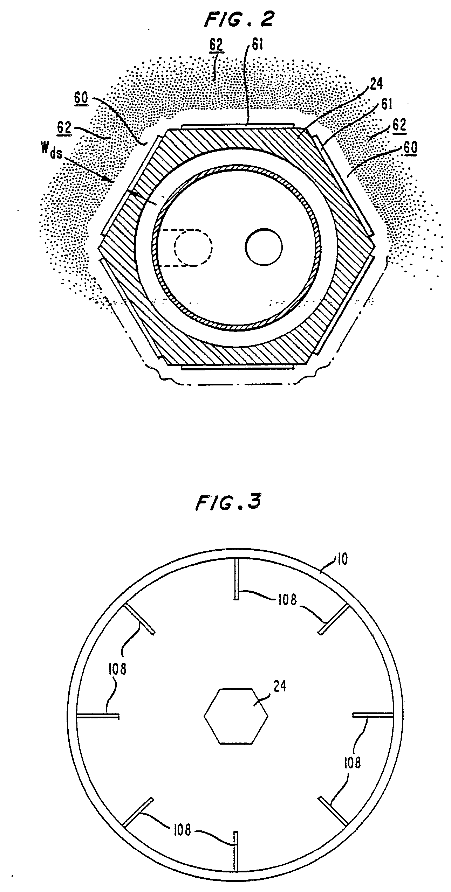

In FIG. 2, which is a top sectional view of the workpiece holder 24 shown in FIG. 1, a dark space 60 is schematically represented as enveloping workpieces 61 mounted on the facets of the hexagonal holder 24. In turn, a radio-frequency-generated plasma 62 is depicted as enveloping the dark space 60. As specified before, this plasma fills the entire space between the dark space and the inner surface of the chamber 10. Additionally, since the elements 50, 52, the collar 56 and the member 58 (see FIG. 1) are electrically connected to the chamber 10, the aforementioned plasma extends to the surfaces of these components also. Hence, the dark space, which in effect defines the regions where etching can occur, is confined in the depicted apparatus to the immediate vicinity of the facets of the holder 24.

Wafer-containing assemblies for each arranged to carry mounting four wafers to be etched on the respective facets of the holder 24 are shown in FIG. 1 (see, for example, assembly 64). The assembly 64 comprises a conductive base plate 66 made, for example, of aluminum. Illustratively, the wafer-holding recesses are cylindrical and just slightly larger in diameter than the respective wafers designed to be placed therein, and have a depth approximately equal to the thickness of the wafers. A nonconductive top plate 70 made, for example, of fused silica (or of aluminum oxide, or of silicon, or comprising a dielectric material deposited on a metallic plate) is secured to the base plate 66 by screws. The diameter of each aperture is slightly less than the diameter of the wafer contained in the recess immediately thereunder. Accordingly, the plate 70 serves to retain the workpieces to be etched in place in the base plate 66. A major portion of the top surface of each retained workpiece is thereby exposed through the respective aperture in the plate 70. When the wafer-containing assemblies are screwed in place on the facets of the holder 24, the top or exposed surfaces of the retained workpieces are mounted in place for etching in the apparatus shown in FIG. 1. When so mounted, the bottom surfaces of the workpieces are maintained in electrical contact with the base plate 66 which, in turn, is in electrical contact with the holder 24. Maintaining good electrical contact between the workpieces and the cathode holder in this manner has been determined to be particularly important when carrying out, for example, anisotropic etching of doped polysilicon.

Various gases are suitable for introduction into the apparatus of FIG. 1 to carry out sputter etching therein. Thus, for example, substantially pure gases such as argon, helium, neon, nitrogen, xenon, krypton or mixtures thereof, or other gaseous atmospheres known in the art to be suitable for sputter etching, can be utilized for sputter etching in the depicted apparatus. In one particular illustrative example, a gold layer on each of multiple wafers was selectively sputter etched within the chamber 10 using a titanium or tantalum masking layer in an atmosphere comprising 80 percent argon and 20 percent dry air by volume. In this example, the holder 24 was driven by an r-f source operating at 13.5 megahertz to provide power at a density of approximately 0.3 watts per square centimeter at the surface of the layers to be etched. Etching of the gold layers occurred at a rate of about 500 Angstrom units per minute when the gas flow into the apparatus was approximately 5-to-20 cubic centimeters per minute and the pressure within the etching apparatus was established in the range 5-to-10 microns.

In an atmosphere of substantially pure argon and under operating conditions that were otherwise the same as those specified above for gold, multiple layers of permalloy were simultaneously sputter etched in the FIG. 1 apparatus at a rate of approximately 300 Angstrom units per minute.

Reactive sputter etching can be carried out in the FIG. 1 apparatus utilizing a variety of gases. Gases such as, for example, substantially pure oxygen, chlorine, $C_2F_6$, $CHF_3$, $ClF_3$, $BCl_3$, $SiF_4$, any one of the freon gases, or mixtures thereof, or mixtures of the aforespecified gases with helium, argon, nitrogen, hydrogen, xenon, neon or krypton, or other gaseous atmospheres known in the art to be suitable for reactive sputter etching, can be utilized for reactive sputter etching in the depicted apparatus. In one particular illustrative example, a thermally grown silicon dioxide layer on each of multiple wafers was selectively etched within the chamber 10 using a photoresist masking layer in an atmosphere comprising substantially pure $CHF_3$. In this example, the holder 24 was driven by an r-f source operating at 13.5 megahertz to provide power at a density of approximately 0.5 watts per square centimeter at the surface of the layers to be etched. Etching of the oxide layers occurred at a rate of about 500 Angstrom units per minute when the gas flow into the apparatus was approximately 5-to-50 cubic centimeters per minute and the pressure within the etching apparatus was established at about 5 microns.

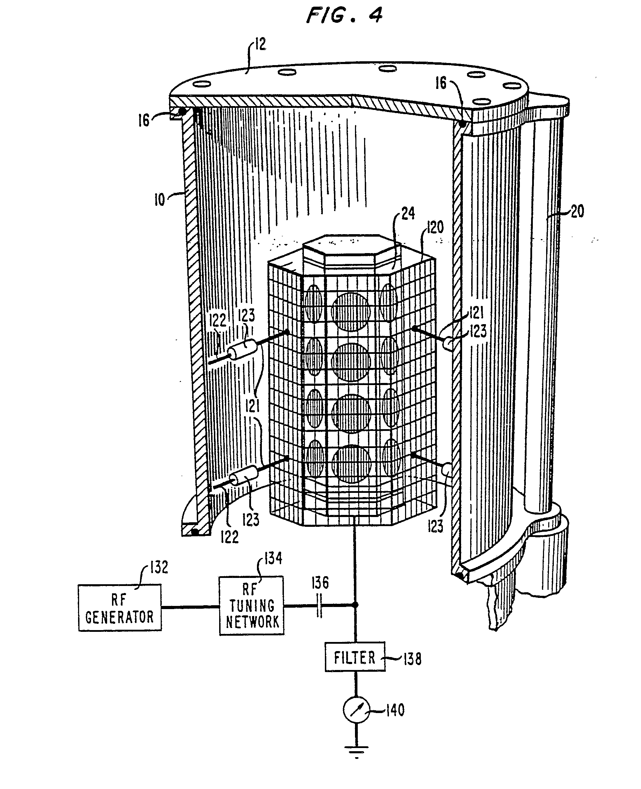

Numerous modifications and alternatives may be devised by those skilled in the art without departing from the spirit and scope of the invention. For example, it is advantageous in some cases of practical importance to modify the inner surface of the chamber 10 of FIG. 1 to include thereon an instrumentality for capturing material sputtered from the holder 24. A honeycomb structure or simply an array of vertically extending vanes 108 (FIG. 3) affixed to the inner surface of the chamber 10 is effective for this purpose. Such a modified structure is also characterized by an especially uniform dark field around the holder 24, whereby highly uniform etching of the multiple workpieces mounted on the holder 24 is achieved. Moreover, because in a structure of the type shown in FIG. 3 the effective anode area is substantially increased, the surface area of the cathode or holder 24 may be correspondingly increased while still maintaining an optimal anode-to-cathode area ratio. Accordingly, the wafer-holding capacity of such a modified structure can be designed to be particularly high.

Another advantageous embodiment of the principles of the present invention is shown in FIG. 4 which represents a modification of the FIG. 1 apparatus. Identical elements in the two figures are designated with the same reference numerals. As will be specified hereinbelow, the FIG. 4 equipment constitutes an advantageous reactive sputter etching apparatus.

In FIG. 4, a grid element 120 is shown mounted in the chamber 10 surrounding the workpiece holder 24. Illustratively, the element 120 is mounted therein by means of plural identical assemblies each of which comprises rigid metallic rod members 121, 122 having an insulating spacer 123 therebetween. In that way, the grid element 120 is, illustratively, maintained in a so-called electrically floating condition with respect to both the anode 10 and the cathode 24 of the depicted apparatus.

By way of a specific illustrative example, the particular grid element 120 shown in FIG. 4 is represented as having six sides each of which is spaced apart from and parallel to a corresponding facet of the hexagonal workpiece holder 24. Other geometries for the element 120 are also feasible. Thus, for example, the element 120 may, alternatively, comprise a conductive cylinder spaced apart from the holder 24 and centrally mounted within the chamber 10.

For the particular hexagonal grid element shown in FIG. 4, six of the aforedescribed mounting assemblies are utilized to hold the grid element 120 in place. Two of these assemblies, which extend between the back side of the element 120 and the inner wall of the chamber 10, are not shown in FIG. 4. The rod members 121 and 122 of the depicted assemblies are spot welded, or otherwise suitably attached in a secure mechanical fashion, to the element 120 and the chamber 10. Accordingly, when the chamber 10 is fully raised upward by means of the arm 20, as described earlier hereinabove, the grid element is also moved upward. In that way, the holder 24 is rendered accessible for mounting workpieces thereon.

The schematically represented grid element 120 of FIG. 4 comprises, illustratively, a lattice of orthogonally disposed overlapping conductive members made, for example, of aluminum or stainless steel strips, wires or rods. But other alternative constructions for the element 120 are also suitable for inclusion in a reactive sputter etching apparatus made in accordance with the principles of the present invention. For example, the element 120 may be formed simply by making apertures in a hexagonal metallic member or in a sheet of metal formed in the shape of a cylinder.

In one particular illustrative embodiment of the FIG. 4 apparatus, the grid element 120 was formed such that the openings therein constituted approximately 50 percent of the total surface area thereof. But other embodiments in which the opening percentage ranges from approximately zero to 90 are also feasible.

In one specific embodiment of applicant's etching apparatus, the distance between each face of the centrally positioned workpiece holder 24 (FIG. 4) and the inner surface of the chamber 10 was approximately 12.7 cm. In that specific embodiment, the grid element 120 was centrally positioned in the depicted apparatus such that each of its faces was about 7.6 cm from the inner surface of the chamber 10. But various other spacings are suitable. In general, the spacing between the holder 24 and the grid element 120 should be at least twice the width $w_{ds}$ (see FIG. 2) of the aforesaid dark space established in the chamber during etching.

As shown in FIG. 4, an r-f generator 132 and an r-f tuning network 134 are electrically connected via capacitor 136 to the workpiece holder 24. By means of a filter 135 and a meter 140, an indication is provided of the peak r-f voltage applied to the holder 24. In one specific illustrative case in which reactive sputter etching was carried out, the potential indicated on the meter 140 was —300 volts.

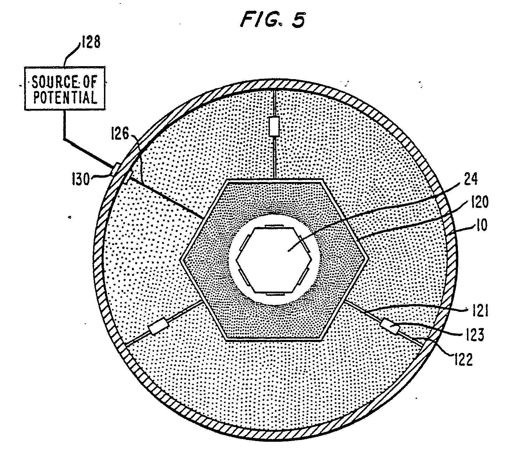

FIG. 5 is a schematic top view of a portion of the FIG. 4 apparatus. As discussed above, the grid element 120 is advantageously mounted in the depicted apparatus in an electrically isolated way to constitute a so-called floating grid. Alternatively, however, it is feasible to carry out reactive sputter etching in such a grid-equipped apparatus by electrically connecting the element 120 directly to an external source of potential 128. Thus, for example, lead 126 shown in FIG. 5 may be utilized to connect the element 120 to the source 128. Illustratively, the lead 126 extends through the chamber 10 via a standard insulating seal 130.

In accordance with a feature of the present invention, the voltage applied to the grid element 120 by the source 128 of FIG. 5 is selected to fall in a specified range. In particular, the range extends, for example, from slightly above ground to a value that is the negative of the peak r-f voltage measured by the meter 140 (FIG. 4).

Fig. 5 schematically depicts the plasma established in the chamber 10 during reactive sputter etching, whether the aforespecified grid is floating or connected to an external source. In the region between the workpiece holder 24 and the grid element 120, a so-called bright plasma is formed, whereas in the space between the element 120 and the chamber 10 a so-called diffuse plasma is established. Illustratively, the density of ions in the holder-to-grid region is at least three times that in the grid-to-chamber space.

A grid-equipped reactive sputter etching apparatus made in accordance with the principles of the present invention exhibits advantageous characteristics. In particular, the difference in etching rate between various materials is increased therein relative to the difference exhibited in such an apparatus that does not include a grid element.

In one specific example of practical importance, a resist-masked layer of polysilicon overlying a layer of silicon dioxide was selectively etched in a grid-equipped reactive sputtering apparatus of the type shown in FIGS. 4 and 5. In a $CF_4$ atmosphere, at an r-f power input setting of 150 watts, with the gas flow into the chamber set at approximately 20 cubic centimeters per minute and the pressure within the chamber established at about 6 microns, the polysilicon layer was etched at a rate of approximately 500 Angstrom units per minute. In that illustrative case, any exposed silicon dioxide was etched at a rate of about 25 Angstrom units per minute. By contrast, under the same conditions, but without a grid in the apparatus, the polysilicon layer is etched at approximately the same rate but, significantly, the silicon dioxide layer is etched at the considerably higher rate of approximately 80 Angstrom units per minute. Moreover, in the grid-equipped apparatus, the masking resist layer is eroded to a lesser extent during etching than is the case when reactive sputter etching is carried out in an apparatus without a grid.

Similarly, the relative reactive sputter etching rates of other materials are enhanced by utilizing an apparatus of the type shown in FIGS. 4 and 5. For example, by employing a standard $CHF_3$ atmosphere in such an apparatus, the etch rate of a resist-masked silicon dioxide layer relative to the etch rate of an underlying polysilicon layer can be thereby significantly increased. In that case, erosion of the masking resist layer is also reduced relative to the erosion thereof that occurs in a gridless apparatus under similar operating conditions.

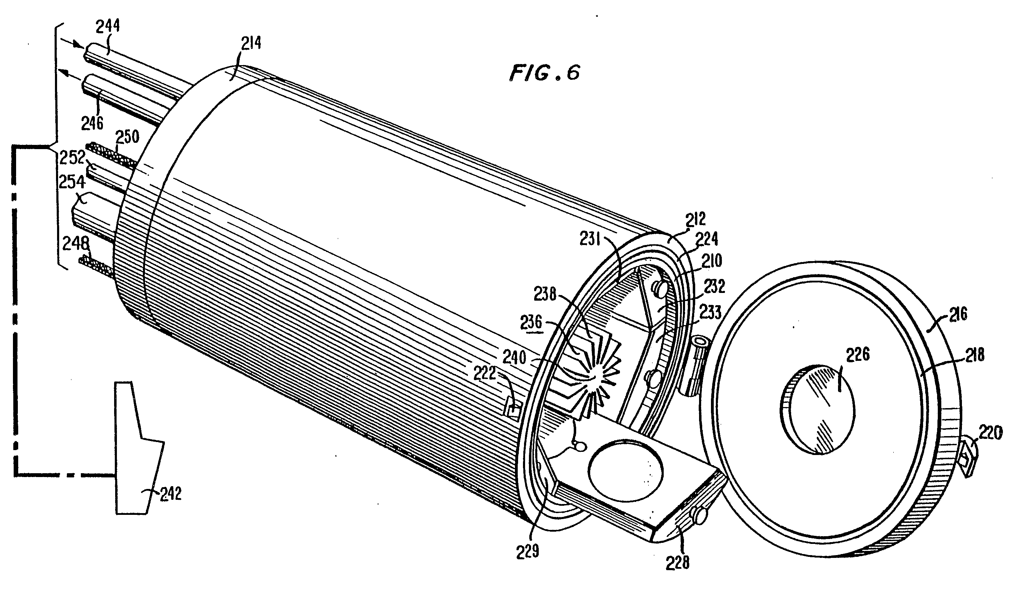

A complete and definitive theory of operation for the reactive sputter etching process that occurs in a grid-equipped apparatus of the type shown in FIGS. 5 and 6 has not been formulated, but a tentative simplified explanation for the improved results specified above has been established. Although the validity and scope of the present invention clearly does not depend to any extent on the accuracy or comprehensiveness of that explanation, it is instructive nevertheless to set it forth briefly herein.

It is speculated that all etching reactions that are primarily physically assisted chemical reactions remain essentially the same for a given set of operating parameters (e.g., power input, type of gas, gas flow, pressure) whether the reactive sputter etching apparatus includes a grid or not. This is confirmed in practice by the fact that the etching rates of the polysilicon layer in the first example set forth above remain essentially the same in the two types of equipment. In those examples, polysilicon is removed during etching primarily due to physically assisted chemical processes. But, in a grid-equipped apparatus, the energy of ions incident on the workpiece surfaces is relatively decreased due to the presence of the grid. In turn, this causes a decrease in the rate of removal of materials which are eroded primarily by a physical etching action. This is confirmed in practice by the observation that the rate of removal of the underlying silicon dioxide layer in the first example set forth above is substantially reduced in a grid-equipped apparatus.

FIG. 6 shows another embodiment in which the cathode surrounds the anode and the anode is made to have a larger surface area than the cathode through the use of vanes 238. The etching apparatus shown in FIG. 6 comprises a cylindrical cathode element 210 made of an electrically conductive material such as, for example, aluminum or stainless steel. A nonconductive cylindrical cladding member 212 made, for example, of glass or ceramic envelops the element 210 and is securely bonded thereto. A disc 214 of such a nonconductive cladding material is utilized to seal the left-hand end of the cylindrical member 12. In turn, the right-hand end of the member 212 is, illustratively, sealed by means of a hinged loading door 216 which has affixed thereto a standard O-ring 218. When the door 216 is secured in its closed position by means of mating latching elements 220 and 222, the O-ring 218 fits in groove 224 formed in the right-hand flat end of the cylindrical member 212. If the door 216 is made of an optically opaque material, a sealed transparent viewing port 226 is advantageously included therein to permit observation of the sealed interior of the depicted apparatus during etching.

In accordance with the principles of the present invention, multiple workpieces to be etched are mounted in a symmetrical array on the inner surface of the cylindrical cathode element 210. By way of a specific example, the particular apparatus shown in FIG. 6 is designed to have six workpiece-retaining tray assemblies 228 through 233 mounted in contact with the inner surface of the element 210. When so mounted, the surface of each assembly faces toward the longitudinal axis of the cylindrical cathode element 210. Illustratively, each depicted tray assembly is adapted to retain six silicon wafers therein. The structure of the tray assemblies and the manner in which they are mounted in place in the depicted apparatus will be specified in detail later below.

The apparatus shown in FIG. 6 includes an anode element 236 centrally disposed with respect to the longitudinal axis of the cylindrical element 210. In accordance with the principles of the present invention, the anode-to-cathode surface area ratio is designed to exceed unity. Illustratively, this ratio is selected to be in the range 1.5 to 10. In one specific illustrative system of the type represented in FIG. 6, this ratio was designed to be approximately 2.6.

The relatively large-area anode element included in a cylindrical etching apparatus may be configured in a variety of ways. As indicated in FIG. 6, the anode element 236 may comprise multiple longitudinally extending conductive vanes 238 emanating symmetrically from and physically supported by a longitudinally extending conductive core portion 240 which is centrally positioned on the longitudinal axis of the element 210. The vanes 238 and the core portion 240 are made, for example, of aluminum or stainless steel.

The area of the anode of the apparatus illustrated in FIG. 6 is the sum of the surface areas of the multiple vanes 238. The effective area of the cathode thereof is approximately the sum of the surface areas of the aforespecified faces of the workpiece-retaining tray assemblies 228 through 233.

In accordance with the principles of the present invention, the anode-to-cathode surface area ratio of a high-throughput etching apparatus is easily varied. This can be done, for example, by mounting the vanes 238 on the core portion 240 in any standard releasable way. Then, by changing the number and/or the areas of the respective vanes mounted on the portion 240, the anode-to-cathode surface area can be conveniently changed. In that way, operating conditions can be easily optimized to achieve specified etching characteristics.

The specific apparatus shown in FIG. 6 constitutes part of an etching system that also includes associated equipment 242 which is conventional in nature. The equipment 242 includes, for example, a vacuum system, gas sources, a high-frequency alternating-current (a-c) power supply adjustable to operate, for example, in the range 8 kHz to 50 mHz, a pumped source of cooling fluid, and associated standard controls and gauges by means of which specified operating conditions of the type set forth later below are established in the chamber 210.

Illustratively, connections between the equipment 242 and the interior of the apparatus shown in FIG. 6 are made through the non-conductive disc 214. As schematically represented in FIG. 6, two fluid-carrying conduits, an inlet pipe 244 and an outlet pipe 246, extend between the equipment 42 and the etching apparatus. In a number of standard ways, fluid carried in the pipes 244 and 246 can be directed through the apparatus to cool wafers mounted therein for etching.

An a-c bus 248 and a reference-potential strap 250 are also indicated in FIG. 6 as extending between the equipment 242 and the depicted barrel reactor. In addition, a gas inlet pipe 252 and a conduit 254 extend therebetween. The pipe 252 is utilized to introduce a specified gas or mixture of gases into the etching apparatus. The conduit 254, which is connected to a standard vacuum pump in the equipment 242, serves to establish a prescribed low-pressure condition in the apparatus.

In accordance with the principles of the present invention, the aforementioned a-c bus 248 shown in FIG. 6 is coupled to the driven cathode element 210. Further, the strap 250, which is connected to a fixed point of reference potential such as electrical ground, is connected to the large-area anode element 236. In response to capacitively coupled a-c excitation of the elements 210 and 236 by the equipment 242, a generally symmetrical plasma and associated dark space are established in the apparatus in the space between the element 236 and the surfaces of multiple wafers mounted on the element 210, as will be specified in detail later below.

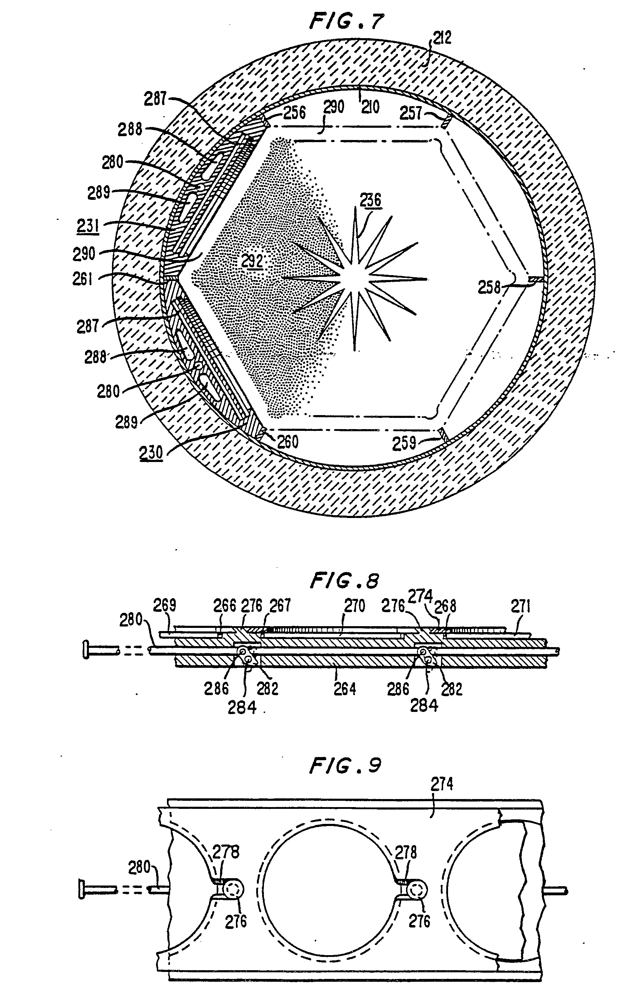

The previously described cathode and anode elements 210 and 236, respectively, and the cladding member 212 are also shown in the sectional view of FIG. 7. Also indicated in FIG. 7 are six longitudinally extending members 256 through 261 made, for example, of aluminum or stainless steel and affixed to the inner surface of the cathode element 210. The members 256 through 261 serve as retaining partitions for holding the aforementioned tray assemblies 228 through 233 in place. Illustratively, two such assemblies 230 and 231 are shown in FIG. 7. As shown, the assembly 230 is mounted between the retaining members 260 and 261, and the assembly 231 between the members 256 and 261, in contact with the inner surface of the cathode element 210. In a similar way, four other wafer-holding tray assemblies are designed to be mounted on the element 210 in the specific herein-considered apparatus.

Details of a specific illustrative tray assembly suitable for mounting on the element 210 are shown in FIGS. 8 and 9. As indicated in the sectional view of FIG. 8, the assembly includes a conductive base plate 264 made, for example, of aluminum. The bottom of the base plate 264 is shaped to match the contour of the inner surface of the element 10 (see FIG. 7). Six wafer-holding recesses are formed in the plate 64. Illustratively, these recesses are cylindrical and just slightly larger in diameter than the respective wafers designed to be placed therein. The depth of the recesses is approximately the same as the thickness of the wafers. Three such recesses 266 through 268, respectively having wafers 269 through 271 therein, are indicated in FIG. 8. A nonconductive top plate 274 (FIG. 9) made, for example, of fused silica (or of aluminum oxide, or of silicon, or comprising a dielectric material deposited on a metallic plate) is positioned on top of the base plate 264. The top plate 274 contains six apertures therethrough in aligned registry with the recesses in the base plate 264. The diameter of each aperture is slightly less than the diameter of the wafer contained in the recess immediately thereunder. Accordingly, the plate 274 serves to retain the workpieces to be etched in place in the base plate 264. A major portion of the top surface of each retained workpiece is thereby exposed through the respective aperture in the plate 274. When the wafer-containing assemblies are mounted in place on the inner surface of the cathode element 210, the exposed surfaces of the retained workpieces are positioned in place for etching in the apparatus described herein. When so positioned, the bottom surfaces of the workpieces are in electrical contact with the base plate 264 which, in turn, is in electrical contact with the element 210. Maintaining good electrical contact between the workpieces and the cathode in this manner has been determined to be particularly important when carrying out, for example, anisotropic etching of doped polysilicon.

One illustrative way in which to secure the top plate 274 in aligned registry with its associated base plate 264 is shown in FIGS. 8 and 9. Studs 276 formed at the top of the base plate 264 are designed to slide in grooves 278 in the top plate 274. When the top plate 274 is slid into position as shown in FIGS. 8 and 9, the studs 276 frictionally engage the plate 274 and hold it in a predesigned retaining orientation with respect to the wafers thereunder.

Illustratively, each tray assembly to be mounted on the inner wall of the cathode element 210 also includes a locking cam rod 280 (see FIGS. 8 and 9) that extends through a centrally positioned cam rod opening in the base plate 264. Additionally, as depicted in FIG. 8, plural locking cams 282 are rotatably mounted by pins 284 to the base plate 264 and by pins 286 to the cam rod 280. After a tray assembly is slid into position between two associated ones of the retaining members 256 through 261, the assembly is mechanically locked in place and established in good electrical contact with the element 210 by depressing the cam rod 280 (from left to right in FIGS. 8 and 9).

Cooling of the workpieces mounted in the depicted etching apparatus is advantageous. Otherwise, heat generated during the etching process may cause material included on the workpiece to flow and thereby deleteriously alter the geometry of the device being fabricated. Moreover, by controlling the temperature of the workpieces to maintain a specified optimal temperature on the surfaces thereof, a relatively uniform and efficient etching action is achieved for materials whose etch rates are temperature dependent.

One specific illustrative way in which to cool the workpieces to be etched is shown in FIG. 7. Fluid-carrying channels 287 through 289 are formed in the base plate 264 of each tray assembly. (So as not to unduly clutter FIGS. 8 and 9, these channels are shown in FIG. 7 but not in FIGS. 8 and 9.) Fluid directed through the channels 287 and returned to the equipment 242 via the channels 288 and 289 is effective to maintain the surfaces to be etched at a specified temperature.

Illustratively, the channels 287 through 289 shown in FIG. 7 can be interconnected internally within the base plate 264 of each mounting assembly near the end that is adjacent to the loading door 216. Similarly, the fluid-carrying channels at the other end of each assembly can be interconnected with the pipes 244 and 246 (FIG. 6) via a conventional plug-in assembly and manifold.

In an apparatus made in accordance with the principles of the present invention, a plasma of the type typically utilized in conventional sputter etching or reactive sputter etching is established in the sealed interior thereof. In particular, a generally symmetrical dark space is formed in the vicinity of the workpieces and a plasma is formed between the dark space and the element 236.

In FIG. 7, a dark space 290 is schematically represented as existing in the immediate vicinity of the mounted workpieces. In turn, a radio-frequency-generated plasma 292 is shown as filling the entire space in the depicted apparatus between the dark space 290 and the anode element 236. The specific illustrative apparatus described herein is adapted to simultaneously etch thirty-six workpieces. The gases used, r-f power and frequency, and other parameters are consistent with the embodiment of FIG. 1, as are the etch rates. However, this embodiment is capable of a higher throughput because of the greater number of workpiece holders.

## Claims

1. Dry etching apparatus of the type that does not include a magnetic field, comprising first (24) and second (10) electrode elements, one of the electrode elements being capacitively coupled to and driven by a source of a-c power, means including the a-c power source for establishing a gas discharge between the first and second electrodes and for eroding material from a workpiece located in contact with one of the electrodes characterized in that the first electrode (24) has a first surface facing the second electrode (10), and the second electrode (10) has a second surface which surrounds the first surface (24), the area of one (24) of said surfaces is smaller than the area of the other surface (10), a plurality of workpieces are located closely adjacent to or on the smaller area surface, and the electrode having the smaller area surface is capacitively coupled to and driven by the source of a-c power for the purpose of causing a dark space to be formed in the immediate vicinity of said workpieces and a plasma to be formed throughout the space between said dark space and said other surface.

2. The apparatus of claim 1 characterized in that the first surface has a smaller area than the second surface and constitutes a cathode electrode.

3. The apparatus of claim 1 characterized in that the second surface has smaller area than the first surface and constitutes a cathode electrode.

4. The apparatus of claims 1—3 characterized in that the ratio of surface areas of the first and second electrode is 1.5 to 10.

5. The apparatus of claim 2 characterized in that the second surface defines a cylindrical chamber and the cathode electrode comprises a conductive multi-faceted wafer holder centrally disposed along the longitudinal axis of said cylindrical chamber.

6. The apparatus of claim 5 characterized in that the wafer holder comprises a conductive member (e.g. 66) having recesses therein for respectively holding workpieces to be etched in electrical contact with the cathode electrode and a nonconductive member (e.g. 70) having plural apertures in alignment with said recesses, the lateral dimensions of each aperture being slightly less than the corresponding lateral dimension of the workpiece to be placed in the associated aligned recess, and means for securing the conductive and nonconductive members together in alignment to hold the workpieces effectively in place in said recesses in electrical contact with the cathode electrode.

7. The apparatus of claim 5 characterized in that the second electrode is connected to a reference potential and constitutes an anode electrode and a grid element (e.g. 120) is included between the cathode electrode and the anode-electrode.

8. The apparatus of claim 7 characterized in that the grid electrode is electrically connected to the source of a-c power.

9. The apparatus of claim 2 characterized in that a plurality of vanes (e.g. 108) extend radially from the second electrode in the direction of the first electrode.

10. The apparatus of claim 3 characterized in that the second surface defines a cylindrical chamber and the first electrode (e.g. 240) is located on the central axis of the cylindrical chamber and includes a plurality of radially extending vanes (e.g. 238).

11. The apparatus of claim 10 characterized in that the second electrode element includes on its inner surface a plurality of axially extending mounting assemblies (e.g. 228) each adapted to hold a plurality of workpieces.

12. The apparatus of claim 1 characterized in that each of the mounting assemblies includes a conductive member (e.g. 264) and a nonconductive member (e.g. 274); each conductive member has a bottom surface contoured to match a portion of the second surface of the cathode electrode and a top surface with a plurality of recesses for holding workpieces; each nonconductive member has a plurality of apertures in aligned registry with said recesses, the diameter of each aperture being slightly smaller than the diameter of the workpiece contained in the associated recess; and means (e.g. 276) for securing conductive and nonconductive members in alignment.

## Revendications

1. Appareil d'attaque par voie sèche du type ne comportant pas un champ magnétique, comprenant des premier (24) et second (10) éléments d'électrode, l'un des éléments d'électrode étant en couplage capacitif avec une source d'énergie alternative et étant excité par cette dernière, des moyens comprenant la source d'énergie alternative destinés à établir une décharge dans un gaz entre les première et seconde électrodes, et à éroder de la matière à partir d'un article placé en contact avec l'une des électrodes, caractérisé en ce que la première électrode (24) comporte une première surface qui fait face à la second électrode (10), et la seconde électrode (10) comporte une seconde surface qui entoure la première surface (24), l'aire de l'une (24) de ces surfaces est plus petite que l'aire de l'autre surface (10), un ensemble d'articles sont placés en position étroitement adjacente à la surface ayant la plus petite aire, ou sur cette surface, et l'électrode ayant la surface dont l'aire est la plus petite est en couplage capacitif avec la source d'énergie alternative et est excitée par cette source, dans le but de provoquer la formation d'un espace sombre au voisinage immédiat des articles et la formation d'un plasma dans tout l'espace situé entre cet espace sombre et ladite autre surface.

2. L'appareil de la revendication 1 caractérisé en ce que la première surface a une aire inférieure à celle de la seconde surface et constitue l'électrode de cathode.

3. L'appareil de la revendication 1 caractérisé en ce que la seconde surface a une aire inférieure à celle de la première surface et constitue l'électrode de cathode.

4. L'appareil selon les revendications 1—3 caractérisé en ce que le rapport des aires de surface de la première électrode et de la seconde électrode est de 1,5 à 10.

5. L'appareil de la revendication 2 caractérisé en ce que la seconde surface définit une chambre cylindrique et l'électrode de cathode consiste en un support de tranches conducteur à facettes multiples, placé en position centrale le long de l'axe longitudinal de la chambre cylindrique.

6. L'appareil selon la revendication 5 caractérisé en ce que le support de tranches comprend un élément conducteur (par exemple 66) contenant des cavités, pour maintenir des articles respectifs à attaquer en contact électrique avec l'électrode de cathode, et un élément non conducteur (par exemple 70) comportant un ensemble d'ouvertures en alignement avec les cavités, les dimensions latérales de chaque ouverture étant légèrement inférieures à la dimension latérale correspondante de l'article à placer dans la cavité alignée associée, et des moyens destinés à fixer ensemble les éléments conducteur et non conducteur, en alignement, pour maintenir effectivement les articles en place dans les cavités en contact électrique avec l'électrode de cathode.

7. L'appareil de la revendication 5 caractérisé en ce que la seconde électrode est connectée à un potentiel de référence et constitue une électrode d'anode, et un élément de grille (par exemple 120) est inclus entre l'électrode de cathode et l'électrode d'anode.

8. L'appareil de la revendication 7 caractérisé en ce que l'électrode de grille est électriquement connectée à la source d'énergie alternative.

9. L'appareil selon la revendication 2 caractérisé en ce que un ensemble d'ailettes (par exemple 108) s'étendent radialement à partir de la seconde électrode dans la direction de la première électrode.

10. L'appareil de la revendication 3 caractérisé en ce que la seconde surface définit une chambre cylindrique et la première électrode (par exemple 240) se trouve sur l'axe central de la chambre cylindrique et comprend un ensemble d'ailettes s'étendant radialement (par exemple 238).

11. L'appareil de la revendication 10 caractérisé en ce que le second élément d'électrode comprend sur sa surface intérieure un ensemble de structures de montage (par exemple 228) s'étendant axialement, chacune d'elles étant prévue pour maintenir un ensemble d'articles.

12. L'appareil de la revendication 11 caractérisé en ce que chacune des structures de montage comprend un élément conducteur (par exemple 164) et un élément non conducteur (par exemple 274); chaque élément conducteur a une surface inférieure profilée de façon à s'adapter à une partie de la seconde surface de l'électrode de cathode, et une surface supérieure comprenant un ensemble de cavités destinées à maintenir des articles; chaque élément non conducteur comporte un ensemble d'ouvertures en alignement concordant avec les cavités, le diamètre de chaque ouverture étant légèrement inférieur au diamètre de l'article contenu dans la cavité associée; et des moyens (par exemple 276) destinés à fixer en alignement les éléments conducteur et non conducteur.

**Patentansprüche**

1. Trockenätzapparat des Typs, der kein Magnetfeld beinhaltet, mit

— ersten (24) und zweiten (10) Elektrodenelementen, wobei eines der Elektrodenelemente an eine Wechselstromquelle kapazitiv angekoppelt und von dieser betrieben ist, und

— eine die Wechselstromquelle umfassende Einrichtung zum Erzeugen einer Gasentladung zwischen den ersten und zweiten Elektroden für einen Materialabtrag von einem Werkstück, das im Kontakt mit einer der Elektroden angeordnet ist, dadurch gekennzeichnet, daß

— die erste Elektrode (24) eine erste Fläche aufweist, die der zweiten Elektrode (10) zugewandt ist,

— die zweite Elektrode (10) eine zweite Fläche aufweist, die die erste Fläche (24) umgibt,

— das Gebiet einer (24) der Flächen kleiner ist als das Gebiet der andern Fläche (10),

— eine Vielzahl Werkstücke dicht benachbart bei oder auf dem kleineren Flächengebiet angeordnet sind und

— die Elektrode des kleineren Flächengebietes mit der Wechselstromquelle kapazitiv gekoppelt und von dieser zu dem Zweck betrieben ist, daß sich ein Dunkelraum in unmittelbarer Nähe der Werkstücke sowie ein Plasma im ganzen Raum zwischen dem Dunkelraum und der anderen Fläche ausbilden.

2. Apparat nach Anspruch 1, dadurch gekennzeichnet, daß

— die erste Fläche das kleinere Gebiet als die zweite Fläche besitzt und die Kathoden-Elektrode bildet.

3. Apparat nach Anspruch 1, dadurch gekennzeichnet, daß

— die zweite Fläche das kleinere Gebiet als die erste Fläche besitzt und die Kathoden-Elektrode bildet.

4. Apparat nach Ansprüchen 1 bis 3, dadurch gekennzeichnet, daß

— das Verhältnis der Flächengebiete von erster und zweiter Elektrode 1,5 bis 10 beträgt.

5. Apparat nach Anspruch 2, dadurch gekennzeichnet, daß

— die zweite Fläche eine zylindrische Kammer definiert und

— die Kathodenelektrode einen polyfacettierten Waferhalter umfaßt, der zentral längs de Längsachse der zylindrischen Kammer angeordnet ist.

6. Apparat nach Anspruch 5, dadurch gekennzeichnet, daß der Waferhalter aufgebaut ist aus

— einem leitenden Glied (z. B. 66) mit Vertiefungen hierin zum jeweiligen Halten von zu ätzenden Werkstücken in elektrischem Kontakt mit der Kathodenelektrode,

— einem nichtleitenden Glied (z. B. 70) mit einer Vielzahl Öffnungen in Ausrichtung mit den Vertiefungen, wobei die seitlichen Abmessungen jeder Öffnung ein wenig kleiner als die entsprechende seitliche Abmessung des in der zugeordneten, hiermit ausgerichteten Vertiefung anzuordnenden Werkstücks sind, und

— einer Einrichtung zum Zusammenhalten von leitendem und nichtleitendem Glied in gegenseitiger Ausrichtung, um die Werkstücke in den Vertiefungen wirksam in Stellung und in elektrischem Kontakt mit der Kathodenelektrode zu halten.

7. Apparat nach Anspruch 5, dadurch gekennzeichnet, daß

— die zweite Elektrode mit einem Bezugspotential verbunden ist und die Anoden-Elektrode bildet und

— ein Gitterelement (z. B. 120) zwischen der Kathoden-Elektrode und der Anoden-Elektrode vorgesehen ist.

8. Apparat nach Anspruch 7, dadurch gekennzeichnet, daß

— die Gitterelektrode mit einer Wechselstromquelle elektrisch verbunden ist.

9. Apparat nach Anspruch 2, dadurch gekennzeichnet, daß

— sich eine Vielzahl Flügel (z. B. 108) von der zweiten Elektrode aus radial in Richtung der ersten Elektrode erstrecken.

10. Apparat nach Anspruch 3, dadurch gekennzeichnet, daß

— die zweite Fläche eine zylindrische Kammer definiert und

— die erste Elektrode (z. B. 240) auf der Mittelachse der zylindrischen Kammer angeordnet ist und eine Vielzahl radial verlaufender Flügel (238) aufweist.

11. Apparat nach Anspruch 10, dadurch gekennzeichnet, daß

— das zweite Elektrodenelement auf seiner Innenfläche eine Vielzahl sich axial erstreckender Montagebauteile (z. B. 228) aufweist, die je zum Halten einer Vielzahl Werkstücke ausgelegt sind.

12. Apparat nach Anspruch 11, dadurch gekennzeichnet, daß

— jedes Montage-Bauteil ein leitendes Glied (z. B. 264) und ein nichtleitendes Glied (z. B. 274) aufweist,

— jedes leitende Glied eine unterseitige Fläche, deren Kontur an die eines Teils der zweiten Fläche der Kathoden-Elektrode angepaßt ist, und eine oberseitige Fläche mit einer Vielzahl Vertiefungen zum Halten von Werkstücken aufweist,

— jedes nichtleitende Glied eine Vielzahl Öffnungen in entsprechender Ausrichtung mit den Vertiefungen aufweist, wobei der Durchmesser jeder Öffnung ein wenig kleiner ist als der des in der zugeordneten Vertiefung befindlichen Werkstücks, und

— eine Einrichtung (z. B. 276) zum Halten des leitenden und des nichtleitenden Gliedes in gegenseitiger Ausrichtung vorgesehen ist.

FIG. 1

## FIG. 2

62 61

60 24

62 61

$W_{ds}$ 62

60

## FIG. 3

10

108

108

108

24

108

108

108

## FIG. 4

## FIG. 5

FIG.6

## FIG. 7

## FIG. 8

## FIG. 9